# EUROPEAN PATENT APPLICATION

(11) **EP 2 244 280 A1**
(43) Date of publication of application: **27.10.2010**
(21) Application number: 09711063.9
(22) Date of filing: 12.02.2009
(51) Int. Cl.: H01L 21/02, H01L 21/3065, H01L 21/324, H01L 27/12

(54) **METHOD FOR TREATMENT OF SURFACE OF SOI SUBSTRATE**

(30) Priority: 14.02.2008 JP 2008033526
(71) Applicant: Shin-Etsu Chemical Co., Ltd., Tokyo 100-0004 (JP)
(72) Inventor: AKIYAMA, Shoji, Annaka-shi Gunma 379-0195 (JP); KUBOTA, Yoshihiro, Annaka-shi Gunma 379-0195 (JP); ITO, Atsuo, Annaka-shi Gunma 379-0195 (JP); TANAKA, Kouichi, Annaka-shi Gunma 379-0195 (JP); KAWAI, Makoto, Annaka-shi Gunma 379-0195 (JP); TOBISAKA, Yuji, Annaka-shi Gunma 379-0195 (JP); TAMURA, Hiroshi, Annaka-shi Gunma 379-0195 (JP)
(74) Representative: Larcher, Dominique
(86) International application number: PCT/JP2009/052312
(87) International publication number: WO 2009/101979

(57) **Abstract**

Disclosed is a method for minimizing thickness variation of a substrate in an anneal step and achieving the smoothing of the surface of the substrate. Specifically disclosed is a method for treating the surface of a SOI substrate, comprising the steps of: treating the surface of the SOI substrate by the PACE method using a plasma or the GCIB method using a gas cluster ion beam; and subjecting the treated substrate to a heat treatment in argon atmosphere or an inert gas atmosphere containing 4 vol% or less of hydrogen so that the treated SOI substrate can be annealed.

## Description

### TECHNICAL FIELD

The present invention relates to a method for treating a surface of a SOI substrate.

### BACKGROUND ART

Silicon-On-Insulator (SOI) wafers have been widely used in order to reduce parasitic capacitances and achieve higher speed devices. In recent years, the demand for thin film SOIs with an SOI layer (silicon layer) of 100 nm or less has been increased for the purpose of forming completely depleted layer type SOI devices. This is because higher speed devices can be expected from thinner SOI layers. For the thin film SOI wafer, the in-plane film thickness profile of the silicon layer is an extremely important factor, and the in-plane uniformity in nanometer-scale is required.
However, it is practically difficult to achieve the nanometer-scale accuracy with a high yield, and it is difficult to make an improvement as it now stands.

As a method for fabricating a thin film SOI with high in-plane uniformity in film thickness, a so-called PACE (Plasma Assisted Chemical Etch: PACE) method, a gas cluster ion beam (Gas Cluster Ion Beam: GCIB) method, etc., have been also proposed. In these methods, the silicon film thickness of an SOI film is measured in advance, the thin film is etched while calibrating based on the thickness profile, thereby forming a uniform thin film silicon layer. Both of the PACE method and GCIB method may conduct etching while correcting the film thickness variation through the scanning of the whole surface of a wafer with a plasma or an ion beam having several mm to several cm in diameter, and thus would be suitable for obtaining a uniform thin film.

However, these methods have disadvantages at the same time. While a silicon wafer including an SOI is required to have a smooth surface (in the order of 0.3 nm or less in terms of root-mean-square roughness [RMS] measured in accordance with JIS R1683:2007), the silicon wafer, which has been subjected to a PACE or GCIB treatment, tends to have a rough surface than before the treatment, thereby it is necessary to polish again after the treatment. The in-plane uniformity in film thickness might deteriorate in the process of the polishing.
As a method for smoothing a rough surface after the PACE or GCIB treatment, high-temperature hydrogen anneal has been proposed (see Non-Patent Document 1), which shows the achievement of a smooth surface through hydrogen anneal at 1200°C for 60 minutes. Hydrogen anneal is known to etch silicon surfaces (see Non-Patent Document 2).
This reference discloses that a silicon layer can be etched at a speed of 60 nm/h or more in a hydrogen atmosphere at 1100°C. Therefore, the hydrogen anneal may be inappropriate for controlling a silicon surface in nanometer-scale

### PRIOR ART DOCUMENTS

Non-Patent Document 1: Isao YAMADA, "Cluster Ion Beam - Basic and Application", Chapter 4
Non-Patent Document 2: Habuka et al., "Haze Generation on Silicon Surface Heated in Ambient at Atmospheric Pressure", J. Electrochem. Soc., Vol.144, No.9, September (1997) pp. 3261-3265

### DISCLOSURE OF THE INVENTION

### Problem to be solved by the invention

The present invention has been made to solve these problems and has an object to minimize the film thickness variation of a substrate in an anneal step, and to provide a method for achieving the smoothing of the surface.

### Means for solving the problem

The present invention has been made to solve these problems. A first aspect of the present invention may provide a method for treating a surface of a SOI substrate, comprising at least the following steps of: treating the surface of the SOI substrate by a PACE method using a plasma or a GCIB method using a gas cluster ion beam; and annealing the treated SOI substrate by subjecting the treated substrate to a heat treatment in argon atmosphere or an inert gas atmosphere containing 4 vol% or less of hydrogen.
A second aspect of the present invention may provide a method for producing a bonded wafer, comprising the following steps of: forming a semiconductor thin film layer on a surface of a handle wafer; treating the surface of the semiconductor thin film layer by a PACE method using a plasma or a GCIB method using a gas cluster ion beam; and annealing the treated SOI substrate by subjecting the treated substrate to a heat treatment in argon atmosphere or an inert gas atmosphere containing 4 vol% or less of hydrogen.

The aforementioned steps can smooth a surface of a SOI substrate treated by the PACE method or the GCIB method so as to have a desired surface roughness while keeping the uniformity in a film thickness.
In addition, the hydrogen concentration of 4 vol% or less in an inert gas atmosphere is less than the lower explosion limit of the hydrogen concentration, which enables relatively safe handling of hydrogen gas, and the etching effect due to the annealing can also be drastically suppressed compared to the etching effect in an atmosphere of 100% hydrogen, thereby keeping the degradation of the uniformity in a film thickness of the substrate to a minimum.

In this case, it is preferable that the heat treatment in the anneal step be carried out at a temperature of 900°C or more and 1250°C or less.

In addition, the inert gas can be any of nitrogen, argon and helium in the anneal step.
In the present invention, the inert gas for use in the anneal step can be appropriately selected from these gases.

In addition, the surface roughness of the substrate can be adjusted in the anneal step so as to be 0.3 nm or less (in the range of 10 µm × 10 µm) in terms of RMS.
As described above, according to the present invention, the smooth surface (in the order of 0.3 nm or less in terms of RMS) required for the production of silicon substrates including SOI substrates can be achieved.

In addition, the handle wafer for the SOI substrate can be any of a silicon wafer, silicon wafer with an oxide film, quartz, glass, sapphire, SiC, alumina and an aluminum nitride.
In the method for treating a surface according to the present invention, the handle wafer for the SOI substrate can be appropriately selected from these materials in accordance with the purpose of a semiconductor device to be manufactured.

### Advantageous Effects of the Invention

As described above, in accordance with the method for treating a surface of a SOI substrate and the method for producing a bonded wafer according to the present invention, the anneal step of applying a heat treatment in argon atmosphere or an inert gas atmosphere containing 4 vol% or less of hydrogen can be carried out to suppress the action of etching more than in the anneal step of applying a heat treatment in an atmosphere of 100% hydrogen.
Therefore, the surface can be smoothed to a desired surface roughness while suppressing the film thickness variation of the SOI substrate which has uniformity in film thickness enhanced through the treatment by the PACE method or the GCIB method.
In addition, when the concentration of the hydrogen contained in the inert gas is 4 vol% or less, the etching effect is suppressed. The hydrogen concentration of not more than the lower explosion limit enables relatively safe handling of hydrogen gas.

### BRIEF EXPLANATION OF DRAWINGS

[FIG. 1] In-plane thickness variation of SOI film before and after PACE treatment, and after annealing (at 1100°C for 4 hours) in each atmosphere
[FIG. 2] The amount of silicon etched (represented by thickness decrease) by anneal (at 1100°C for 4 hours) in each atmosphere
[FIG. 3] Surface roughness after annealing (at 1100°C for 4 hours) in each atmosphere

### BEST MODE FOR CARRYING OUT THE INVENTION

The present invention will be described below in detail.
As described above, a SOI substrate, i.e. a substrate on a surface of handle wafer a semiconductor thin film layer is formed, is conventionally prepared by the SiGen method followed by the PACE method or the GCIB method in order to produce a SOI substrate having highly uniform film thickness. While this treatment of the PACE method or the GCIB method may improve the uniformity of a film thickness, this treatment also has a problem of roughening the surface of the substrate. Therefore, in order to smooth the roughened surface, methods such as re-polishing and anneal in an atmosphere of 100% hydrogen are suggested but thereby degrading the uniformity in a film thickness.

The inventors have been studied in order to solve these problems.
Basically, a PACE method and a GCIB method are both suitable for etching a silicon layer having the thickness variation of film while correcting errors in thickness profiles of the silicon layer. Given by the above facts, for obtaining a smooth surface of a SOI substrate treated by the PACE method or the GCIB method, it has been found that a heat treatment in argon atmosphere or an inert gas atmosphere containing 4 vol% or less of hydrogen may suppress the etching action and thereby allowing the film thickness to be controlled in nanometre-scale. Therefore, a sufficiently smooth substrate can be obtained while reducing the film thickness variation.
Furthermore, it has been also found that the hydrogen concentration of 4 vol% or less can suppress the action of etching, and the hydrogen concentration of the lower explosion limit or less makes the handling relatively safe, thereby completing the present invention.

While embodiments of the present invention will be described hereinafter, the present invention is not limited to the embodiment.

First, a SOI substrate is prepared (step a).
The method for producing the SOI substrate to be prepared is not particularly limited. A donor wafer may be a polycrystalline or single-crystalline silicon wafer with an ion-implanted region formed by hydrogen ion implantation, or a silicon wafer with an oxide film from a surface of which hydrogen ions are implanted (the film thickness of the oxide film: about several nm to 500 nm). Subsequently, a surface of a handle wafer is subjected to a plasma activation treatment and bonded to the donor wafer, and subjected to a heat treatment at 350°C or less so that the bond strength can be increased. Thereafter, a mechanical shock is applied to the ion-implanted region so as to split along the ion-implanted region to form a SOI substrate. According to such a method for preparing a SOI substrate, a SOI substrate with a relatively uniform thickness of a silicon film can be prepared, thus allowing the time necessary for the step of the treatment by the PACE or the GCIB method and the time necessary for the subsequent anneal step to be reduced, and furthermore allowing much higher uniformity in film thickness to be achieved. Therefore, the method for treating a surface according to the present invention is effective.
As the method for producing the SOI substrate, a production method other than the SiGen method may be used, e.g. a so-called smart cut method. The use of the SiGen method eliminates the need for any high temperature treatment, and is thus preferred in the case of bonding different types of substrates.
In this case, the handle wafer for the SOI substrate can be any of a silicon wafer, silicon wafer with an oxide film, quartz, glass, sapphire, SiC, alumina and aluminum nitride. The handle wafer may be appropriately selected from these materials in accordance with the purpose of a semiconductor device to be manufactured. Of course, materials other than these materials may be used.
The layer thickness of the SOI layer can be, for example, 500 nm or less, because re-polishing is not necessary in the subsequent step, and it is not necessary to secure the polishing allowance for re-polishing.

Next, the surface of the prepared SIO substrate is treated by a PACE method using a plasma or a GCIB method using a gas cluster ion beam (step b).
The PACE method refers to a method in which the thickness of a substrate (the film thickness of an SOI layer) is made uniform while locally etching the surface of the substrate with the use of plasma gas, and the uniformity of the SOI layer in film thickness can be improved by measuring thickness profiles of the SOI layer by an optical interference method or an electrostatic capacitance method and then etching with a plasma gas while controlling the amount of removal based on the measured thickness profiles.
The GCIB method refers to a method of forming a massive atom cluster (gas cluster) of a gaseous substance, applying electrons to the cluster to generate gas cluster ions, and accelerating the gas cluster ions with an accelerating voltage to irradiate the surface of a substrate with the accelerated gas cluster ions, and in the same way as in the PACE method, the uniformity of the SOI layer in film thickness can be improved by measuring thickness profiles of the SOI layer by an optical interference method or an electrostatic capacitance method and then etching with gas cluster ions by controlling the amount of removal based on the measured thickness profiles.

Next, the SOI substrate is subjected to an anneal treatment (step c).
In this way, the application of the anneal treatment to the SOI substrate with its surface roughened by the PACE method or the GCIB method can provide a smooth surface which is highly uniform in film thickness and required for the SOI substrate.

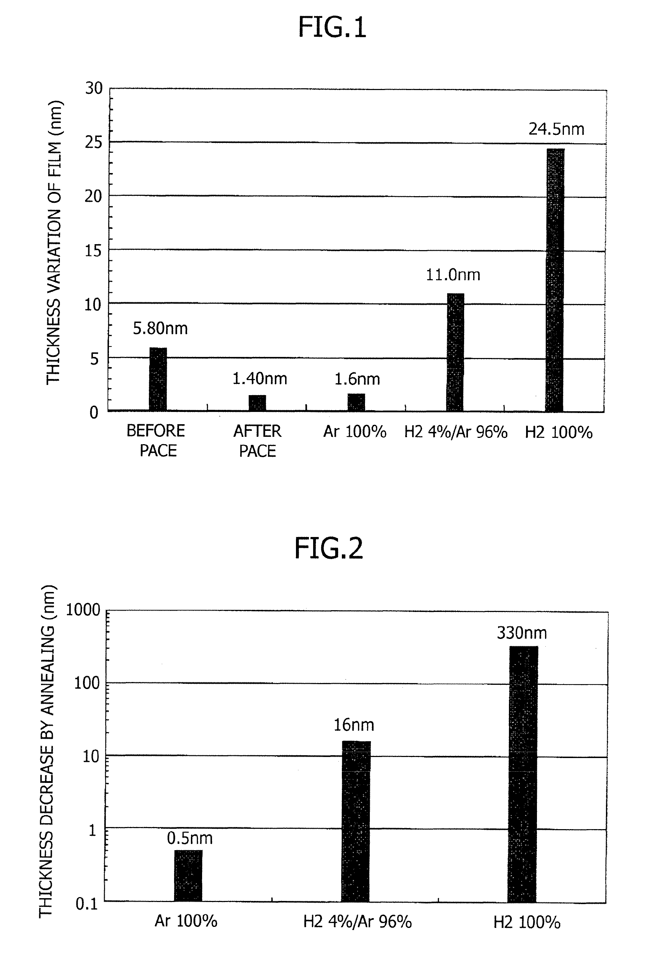

In this case, in the present invention, the SOI substrate is subjected to a heat treatment in argon atmosphere or an inert gas atmosphere containing 4 vol% or less of hydrogen in the anneal step.
As shown in FIG. 2, the SOI substrate subjected to a PACE treatment at 1100°C for 4 hours was annealed in each of argon atmosphere, an inert gas (argon used for the data shown in FIG. 2) atmosphere containing 4 vol% or less of hydrogen, and an atmosphere of 100% hydrogen. In these cases, the thickness decrease of silicon substrate was 330 nm in the atmosphere of 100% hydrogen whereas the thickness decrease was 0.5 nm in the argon atmosphere and 16 nm in the inert gas atmosphere containing 4 vol% or less of hydrogen. Therefore, the argon atmosphere or the inert gas atmosphere containing 4 vol% or less of hydrogen can drastically suppress the action of etching, as compared with the atmosphere of 100% hydrogen, and control the action of etching in nanometer-scale in the process of smoothing the surface of the SOI substrate, thereby allowing the film thickness variation to be reduced for keeping the high uniformity in film thickness.
In addition, the hydrogen concentration of 4 vol% or less in the inert gas can suppress the action of etching, and brings the hydrogen concentration into the lower explosion limit or less, thus making the handling relatively safe.
For easy handling, the pressure (total pressure) of argon gas or the argon/hydrogen mixture gas is desirably about 10⁵ Pa (around 1 atmosphere), i.e. around atmospheric pressure.

In this case, it is preferable to carry out the heat treatment in the anneal step at a temperature of 900°C or more. The anneal treatment at 900°C or more allows the surface of the SOI substrate to have a sufficient surface roughness. In addition, any of nitrogen, argon and helium may be suitable for the inert gas because these gases have substantially no etching action on silicon.
The aforementioned anneal step may control the surface roughness of SOI substrate into 0.3 nm or less (10 µm × 10 µm) in terms of RMS with more certainty. Therefore, the anneal step according to the present invention can achieve a smooth surface required for the SOI substrate while keeping the uniformity in film thickness.
The upper limit of the anneal treatment temperature can be, for example, 1250°C, from the standpoint of the heatproof temperature of a quartz tube or the like. In view of the durability of the quartz member, the anneal treatment temperature is preferably about 1150°C.

Then, through the steps (a to c) described above, a SOI substrate can be produced which is highly uniform in film thickness and has a smooth surface.

In the present invention, as described above, the heat treatment of the SOI substrate in the argon atmosphere or the inert gas atmosphere containing 4 vol% or less of hydrogen in the step c of the anneal step can suppress the action of etching by the anneal, and thus smooth the surface of the SOI substrate while keeping the uniformity of the SOI substrate in film thickness.

### Examples

While the present invention will be described more specifically with reference to examples of the present invention and a comparative example, the present invention is not limited to the examples.

### (Example 1)

A SOI substrate was produced as follows in accordance with the method for producing a SOI substrate according to the bonding method.
First, a SOI substrate was prepared by the SiGen method (step a).
In this step, a silicon wafer with an ion-implanted region formed by implanting hydrogen ions under the implantation conditions: an implantation energy of 35 keV; an implantation dose of 9 × 10¹⁶ /cm²; and an implantation depth of 0.3 µm was prepared as a donor wafer, whereas a synthetic quartz substrate was prepared as a handle wafer, and the surfaces to be attached were subjected to a high-frequency plasma activation treatment for 10 seconds, by using a nitrogen gas as a gas for plasma and applying a high frequency between parallel plate electrodes under the condition of high-frequency power of 50 W to generate a plasma.
Next, the donor wafer and the handle wafer were laminated, and the laminate was subjected to a heat treatment at 350°C to increase the bond strength, then the marker for separation was formed by use of an edge of scissors, and a mechanical shock was applied to the ion-implanted region to split along the ion-implanted region, thereby preparing a SOI substrate.
The in-plane thickness variation of film was 5.80 nm for the SOI substrate obtained in accordance with the step described above.

Next, the SOI substrate was treated by a PACE method (step b).
In this step, the thickness distribution of the SOI substrate was measured by an optical interference method, and then, a SF₆ gas was used as an etching gas to carry out etching in response to the thickness distribution. During the treatment, the flow rate of the SF₆ gas, the pressure in the reaction chamber, and the high-frequency power were kept respectively at 40 sccm, 267 Pa, and 125 W.
After the PACE treatment, the surface roughness of the SOI substrate was 3.10 nm in terms of RMS, and the in-plane thickness variation of film was 1.40nm. The in-plane thickness variation of film herein, which is an index of the uniformity in film thickness, refers to a value defined by square-root of sum of squares of deviations in film thickness from the average thickness value for 361 measurement points provided in a radial fashion, and the film thickness mentioned above refers to a value measured by the optical interference method or the electrostatic capacitance method.

Next, the SOI substrate was annealed (step c).
In this step, the annealing was carried out at a temperature of 1100°C for 4 hours in an atmosphere of 100% argon.
In this case, the decrease in film thickness (etching amount) for the SOI substrate was 0.5 nm, the surface roughness after the treatment was 0.26 nm in terms of RMS, and the in-plane thickness variation of film was 1.6 nm.
As described above, the surface roughness of the SOI substrate subjected to the annealing in the atmosphere of 100% argon was RMS 0.3 nm or less, which is a desirable surface roughness.

### (Example 2)

This example was implemented in the same way as in Example 1, provided that the anneal step (step c) was carried out in argon atmosphere containing 4 vol% of hydrogen. In this case, the decrease in film thickness (etching amount) for the SOI substrate was 16 nm, the surface roughness was 0.19 nm in terms of RMS, and the in-plane thickness variation of film was 11.0 nm.
As described above, the surface roughness of the SOI substrate was also RMS 0.3 nm or less in the case of the annealing in the argon atmosphere containing 4 vol% of hydrogen.

### (Comparative Example)

This comparative example was implemented in the same way as in Example 1, provided that the anneal step (step c) was carried out in an atmosphere of 100% hydrogen. In this case, the decrease in film thickness (etching amount) for the SOI substrate was 330 nm, the surface roughness was 0.14 nm in terms of RMS, and the in-plane thickness variation of film was 24.5 nm.

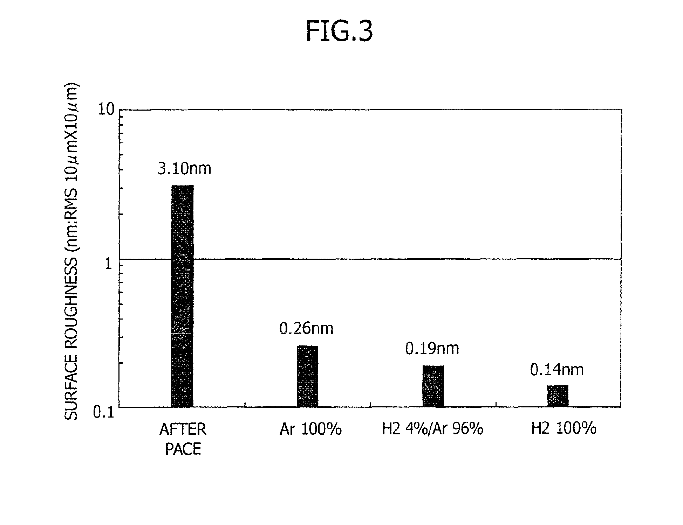

The results of the examples and comparative example described above are shown in FIGS. 1 to 3. As show in FIG. 2, the etching action can be significantly suppressed according to the present invention, compared to the conventional annealing method in a 100 % hydrogen atmosphere, thus allowing the thickness to be controlled in nanometre-scale while suppressing the decrease in film thickness. In addition, as shown in FIG. 1, the present invention may relatively reduce the in-plane thickness variation of the SOI substrate caused by annealing, thus keeping the uniformity in film thickness. Furthermore, as shown in FIG. 3, it has been apparent that the present invention allows the surface roughness of the SOI substrate to be smoothed to a desired surface roughness (RMS 0.3 nm or less).

It should be noted that the present invention is not limited to the embodiments described above. The embodiments are given just as an example, and the technical scope of the present invention encompasses any embodiments as long as the embodiments involve substantially the same construction as and produce similar operation and effect to the technical idea as recited in the claims of the present invention.

## Claims

1. A method for treating a surface of a SOI substrate, comprising the steps of:
treating the surface of the SOI substrate by the PACE method using a plasma or the GCIB method using a gas cluster ion beam; and
subjecting the treated substrate to a heat treatment in argon atmosphere or an inert gas atmosphere containing 4 vol% or less of hydrogen so that the treated SOI substrate can be annealed.

2. The method for treating a surface of a SOI substrate according to claim 1, wherein the heat treatment in the anneal step is carried out at a temperature of 900 °C to 1250 °C.

3. The method for treating a surface of a SOI substrate according to claim 1 or 2, wherein the inert gas in the anneal step is selected from the group consisting of nitrogen, argon and helium.

4. The method for treating a surface of a SOI substrate according to claim 1, wherein the surface roughness of the substrate is adjusted in the anneal step so as to be 0.3 nm or less (in the range of 10 µm × 10 µm) in terms of root-mean-square.

5. The method for treating a surface of a SOI substrate according to claim 1, wherein a handle wafer for the SOI substrate is selected from the group consisting of a silicon wafer, silicon wafer with an oxide film, quartz, glass, sapphire, SiC, alumina and aluminum nitride.

6. The method for treating a surface of a SOI substrate according to claim 1, the SOI substrate to be subjected to the surface treatment is prepared by:
providing a silicon wafer with an ion-implanted region as a donor wafer;
subjecting at least one surface to be bonded of the donor wafer and a handle wafer to a plasma activation treatment;
bonding the donor wafer and the handle wafer to make a laminate;
subjecting the laminate to a heat treatment at 350 °C or less so that the bond strength can be increased; and
applying a mechanical shock to the ion-implanted region to split along the ion-implanted region.

7. A method for producing a bonded wafer, comprising the steps of:
forming a semiconductor thin film layer on a surface of a handle wafer;
treating a surface of the semiconductor thin film layer by the PACE method using a plasma or the GCIB method using a gas cluster ion beam; and
subjecting the semiconductor thin film layer to a heat treatment in argon atmosphere or an inert gas atmosphere containing 4 vol% or less of hydrogen so that the semiconductor thin film layer can be annealed.

8. The method for producing a bonded wafer according to claim 7, wherein the heat treatment in the anneal step is carried out at a temperature of 900 °C to 1250 °C.

9. The method for producing a bonded wafer according to claim 7 or 8, wherein the inert gas in the anneal step is selected from the group consisting of nitrogen, argon and helium.

10. The method for producing a bonded wafer according to claim 7, wherein the surface roughness of the semiconductor thin film layer is adjusted in the anneal step so as to be 0.3 nm or less (in the range of 10 µm × 10 µm) in terms of root-mean-square.

11. The method for producing a bonded wafer according to claim 7, wherein the handle wafer is selected from the group consisting of a silicon wafer, silicon wafer with an oxide film, quartz, glass, sapphire, SiC, alumina and aluminum nitride.

12. The method for producing a bonded wafer according to claim 7, the semiconductor thin film layer subjected to the surface treatment is prepared by:
using a silicon wafer with an ion-implanted region for a donor wafer;
subjecting at least one surface to be bonded of the donor wafer and a handle wafer to a plasma activation treatment, followed by bonding the donor wafer with the handle wafer to make a laminate; and then
subjecting the laminate to a heat treatment at 350°C or less so that the bond strength can be increased; and then
applying a mechanical shock to the ion-implanted region to split along the ion-implanted region.
